# FASCICULE DE BREVET EUROPEEN

(11) **EP 3 263 519 B1**
(45) Date de publication et mention de la délivrance du brevet: **10.11.2021**
(21) Numéro de dépôt: 17178042.2
(22) Date de dépôt: 27.06.2017
(51) Int. Cl.: B82Y 10/00, B82Y 40/00, C01B 32/16, H01L 29/06

(54) **PROCEDE D'HOMOGENEISATION DE LA HAUTEUR D'UNE PLURALITE DE FILS**
HOMOGENISIERUNGSVERFAHREN DER HÖHE EINER VIELZAHL VON FÄDEN
METHOD OF HOMOGENISING THE HEIGHT OF A PLURALITY OF WIRES

(30) Priorité: 29.06.2016 FR 1656088
(43) Date de publication de la demande: 03.01.2018
(73) Titulaire: Commissariat à l'Energie Atomique et aux Energies Alternatives, 75015 Paris (FR)
(72) Inventeur: EYMERY, Joël, 38360 SASSENAGE (FR); EL KACIMI, Amine, 38000 GRENOBLE (FR)
(74) Mandataire: Cabinet Camus Lebkiri

(56) Documents cités:
- EP-A2- 1 087 413
- US-A1- 2003 189 202
- US-A1- 2015 318 071

## Description

### DOMAINE TECHNIQUE DE L'INVENTION

Le domaine technique de l'invention est celui de la fabrication de fils. La présente invention concerne la fabrication d'une pluralité de fils dressés sur un substrat et en particulier un procédé d'homogénéisation de la hauteur d'une pluralité de fils dressés sur un substrat.

### ARRIERE-PLAN TECHNOLOGIQUE DE L'INVENTION

Les fils de semi-conducteur sont utilisés dans de nombreuses applications telles que des dispositifs à DEL (pour Diode Electroluminescente) ou bien encore des capteurs piézoélectriques. Ces fils sont habituellement obtenus par croissance à l'aide de différents procédés tels que la MOVPE (pour *Metalorganic Vapour Phase Epitaxy* en anglais ou épitaxie en phase vapeur aux organométalliques), la croissance hydrothermale, MBE (pour Molecular Beam Epitaxy ou épitaxie par jet moléculaire) ou HVPE (pour Hydride Vapour Phase Epitaxy). Ces procédés ont l'avantage de garantir une structure unidimensionnelle et une très haute qualité cristalline. En revanche, la morphologie des fils, et notamment leur hauteur, n'est pas toujours contrôlée lors du processus de croissance. Une solution envisageable est le recours à des substrats spécifiques mais cela suppose également un procédé de fabrication plus couteux et plus long. Il est également possible d'avoir recours à des procédés de « planarisation » tel que le polissage mécano-chimique, mais l'usage de tels procédés génère des débris de taille micro ou nanométrique qu'il est très difficile d'éliminer et qui peuvent perturber le fonctionnement d'un dispositif utilisant de tels fils. En outre, de tels procédés mécano-chimiques ne sont pas compatibles avec les couches molles et flexibles telles que des couches de PDMS (ou polydiméthylsiloxane) ou de parylène.

EP 1 087 413 A2 (LUCENT TECHNOLOGIES INC [US]) 28 mars 2001 (2001-03-28) décrit un procédé permettant d'obtenir des fils homogènes.

Il existe donc un besoin d'un procédé permettant d'obtenir des fils homogènes sans avoir recours à des substrats spécifiques et sans générer de débris au niveau de la surface du substrat.

### RESUME DE L'INVENTION

L'invention offre une solution aux problèmes évoqués précédemment, en permettant d'obtenir une pluralité de fils de hauteur homogène, à partir de ladite pluralité de fils dressés sur un substrat, à l'aide d'un procédé comprenant une première étape de dépôt d'un premier film d'une première hauteur, une deuxième étape de dépôt d'un deuxième film d'une deuxième hauteur et une étape de retrait du deuxième film. Le retrait de ce deuxième film est effectué en exerçant une contrainte mécanique qui vient rompre les fils. On obtient ainsi des fils dont la hauteur maximale est fixée par la première hauteur du premier film. De plus, l'ensemble étant noyé dans la première ou la deuxième couche lors de la rupture, aucun débris n'est généré au niveau de la surface du substrat.

Pour cela, un premier aspect de l'invention concerne un procédé d'homogénéisation de la hauteur d'une pluralité de fils à partir de ladite pluralité de fils dressés sur une face d'un substrat, le procédé comprenant :
- une première étape de dépôt d'un premier film sur la face du substrat comprenant la pluralité de fils, ledit premier film noyant la pluralité de fils sur une première hauteur ;
- une deuxième étape de dépôt d'un deuxième film sur le premier film, ledit deuxième film noyant au moins une partie de la pluralité de fils sur une deuxième hauteur ;
- une étape de retrait du deuxième film, la partie des fils de la pluralité de fils noyée dans le deuxième film étant retirée en même temps que ledit deuxième film ;
une contrainte mécanique entre le premier film et le deuxième film étant exercée lors de l'étape de retrait.

On entend par fil un élément solide ayant un aspect de forme élevé selon l'une de ces dimensions, les deux autres dimensions étant sensiblement du même ordre de grandeur, ledit fil pouvant-être plein ou creux (par exemple des nanotubes de carbone), de structure homogène ou non (par exemple à hétérostructure radiale ou longitudinale). Ces fils peuvent notamment être obtenus par dépôt, par croissance, par extrusion, par assemblage mécanique, par gravure ou bien encore par séparation de phase. De manière plus générale, tout procédé permettant d'obtenir une structure allongée peut être utilisée. Les fils peuvent présenter une taille millimétrique, micrométrique ou bien encore nanométrique. On entend par fils millimétrique (micrométrique/nanométrique) un fils dont l'une au moins des dimensions est de l'ordre du millimètre (micromètre/nanomètre). On entend par dressé le fait que l'axe principal du fil, c'est-à-dire l'axe parallèle à la plus grande des dimensions du fil, est hors du plan, de préférence en formant avec ce dernier un angle supérieur à 30°, avantageusement supérieur à 45°. Autrement dit, l'axe principal du fil et l'axe normal à la surface forme un angle inférieur à 60°, avantageusement inférieur à 45°. On définit ainsi la hauteur d'un fil par la projection de la longueur du fil sur l'axe normal à la surface du substrat. Autrement dit, lorsque l'axe principal d'un fil est normal à la surface, alors la longueur et la hauteur dudit fil sont égales. Ainsi, lorsque l'axe normal des fils de la pluralité de fils est normal à la surface du substrat, le procédé d'homogénéisation de la hauteur d'une pluralité de fils réalise également une d'homogénéisation de la longueur de ladite pluralité.

On entend par procédé d'homogénéisation un procédé qui permet d'exercer un contrôle sur la hauteur maximale des fils de la pluralité de fils mais également, lorsque l'application envisagée le nécessite, sur la hauteur minimale desdits fils. Dans ce dernier cas, comme il sera expliqué dans la suite, les fils de la pluralité de fils ont tous la même hauteur ou, autrement dit, une hauteur parfaitement homogène.

Grâce au procédé selon un premier aspect de l'invention, on obtient une pluralité de fils dont la hauteur maximale est sensiblement égale à la hauteur du premier film. En effet, la contrainte mécanique imposée lors de l'étape de retrait va venir casser les fils au niveau de l'interface entre le premier film et le deuxième film. Les fils vont alors se retrouver en deux parties, une première partie va demeurer dans le premier film et une deuxième partie va demeurer dans le deuxième film, la deuxième partie étant donc éliminée lors de l'étape de retrait. La contrainte mécanique peut par exemple être exercée en effectuant un retrait par pelage du deuxième film. De manière générale, toute technique de retrait permettant de générer une contrainte mécanique peut être utilisée. Comme expliqué précédemment, le procédé selon l'invention présente également l'avantage de ne pas entrainer la formation de débris au niveau de la surface. L'étape de nettoyage *post* « planarisation » n'est plus nécessaire. Il est en outre compatible avec l'utilisation de couches molles telles que des couches de PDMS, de parylène, de PVN (ou nitrate de polyvinyle) de PEN (ou polynaphtalate) ou de PVDF (ou polyfluorure de vinylidène) par exemple. De plus, la première hauteur ou la deuxième hauteur sont des paramètres qu'il est facile de contrôler par des technique d'étalement centrifuge (ou *spin coating).* Les procédés de pelage sont également bien maitrisés et permettent d'exercer de manière contrôlée la contrainte mécanique nécessaire à la rupture des fils.

Outre les caractéristiques qui viennent d'être évoquées dans le paragraphe précédent, le procédé selon un aspect de l'invention peut présenter une ou plusieurs caractéristiques complémentaires parmi les suivantes, considérées individuellement ou selon toutes les combinaisons techniquement possibles.

Avantageusement, la première hauteur est inférieure ou égale à la hauteur du fil le moins haut de la pluralité de fils. Ainsi, on s'assure que tous les fils ont une hauteur inférieure ou égale à la hauteur du fil le moins haut.

Avantageusement, le procédé selon l'invention comprend, entre la première étape de dépôt et la deuxième étape de dépôt, une troisième étape de dépôt d'une couche d'antiadhésif. Ainsi, l'étape de retrait est facilitée, la séparation se faisant en général au niveau de l'interface ayant l'énergie de liaison la plus faible, l'antiadhésif restant parfois partiellement sur les deux surfaces.

Avantageusement, le procédé selon l'invention comprend, après l'étape de retrait du deuxième film une étape de retrait de la couche d'antiadhésif. Ainsi, lorsque l'étape de retrait du deuxième film n'entraine pas le retrait complet de la couche d'antiadhésif, cette étape permet de supprimer cette couche.

Avantageusement, le procédé selon l'invention comprend, après l'étape de retrait du deuxième film ou l'étape de retrait de la couche d'antiadhésif, une étape de retrait du substrat, le premier film formant alors une membrane comportant une pluralité de fils de hauteur homogène. Ainsi, on obtient une membrane comportant des fils dont la hauteur est homogène.

Avantageusement, le procédé selon l'invention comprend, après l'étape de retrait du deuxième film ou l'étape de retrait de la couche d'antiadhésif, une étape de retrait du premier film. Ainsi, on obtient un substrat comportant sur une de ces faces une pluralité de fils de hauteur homogène

Un deuxième aspect de l'invention concerne un dispositif comportant une pluralité de fils obtenue à l'aide d'un procédé selon un premier aspect de l'invention.

Avantageusement le dispositif est un dispositif piézoélectrique de type capteur ou de type nanogénérateur. Ainsi, on obtient un dispositif comprenant des fils de hauteur homogène ce qui garantit une bonne homogénéité de la détection de tension ou de la génération de courant.

Avantageusement, le dispositif est un dispositif optoélectronique, par exemple électroluminescent. Ainsi, le dispositif électroluminescent obtenu comprend des fils de hauteur homogène ce qui garantit une bonne homogénéité de la lumière émise.

L'invention et ses différentes applications seront mieux comprises à la lecture de la description qui suit et à l'examen des figures qui l'accompagnent.

### BREVE DESCRIPTION DES FIGURES

Les figures sont présentées à titre indicatif et nullement limitatif de l'invention.
- La figure 1 montre un ordinogramme d'un premier mode de réalisation d'un procédé selon un premier aspect de l'invention.
- Les figures 2A à 2E montrent les différentes étapes du premier mode de réalisation d'un procédé selon un premier aspect de l'invention.
- La figure 3 illustre la formation de dislocations dans la base d'un fil.
- Les figures 4A et 4B montrent deux étapes d'une variante du premier mode de réalisation d'un procédé selon un premier aspect de l'invention.
- La figure 5 montre un ordinogramme d'un deuxième mode de réalisation d'un procédé selon un premier aspect de l'invention.
- Les figures 6A à 6E montrent les différentes étapes du deuxième mode de réalisation d'un procédé selon un premier aspect de l'invention.
- Les figures 7A et 7B montrent deux étapes d'une variante du deuxième mode de réalisation d'un procédé selon un premier aspect de l'invention.
- Les figures 8A et 8B montrent deux étapes d'une variante du premier ou du deuxième mode de réalisation d'un procédé selon un premier aspect de l'invention.
- Les figures 9A et 9B montrent deux étapes d'une variante du premier ou du deuxième mode de réalisation d'un procédé selon un premier aspect de l'invention.
- La figure 10A montre un capteur piézoélectrique de l'art antérieur.
- La figure 10B montre un capteur piézoélectrique selon un premier mode de réalisation d'un deuxième aspect de l'invention.
- La figure 11A montre un dispositif électroluminescent de l'art antérieur.
- La figure 11B montre un dispositif électroluminescent selon un deuxième mode de réalisation d'un deuxième aspect de l'invention.

### DESCRIPTION DETAILLEE

Sauf précision contraire, un même élément apparaissant sur des figures différentes présente une référence unique.

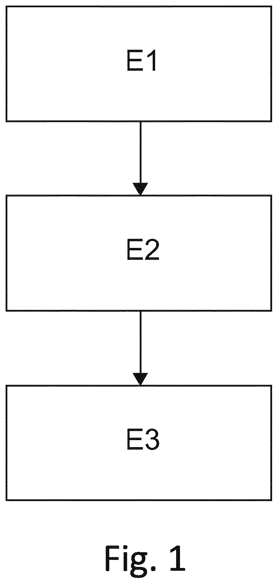

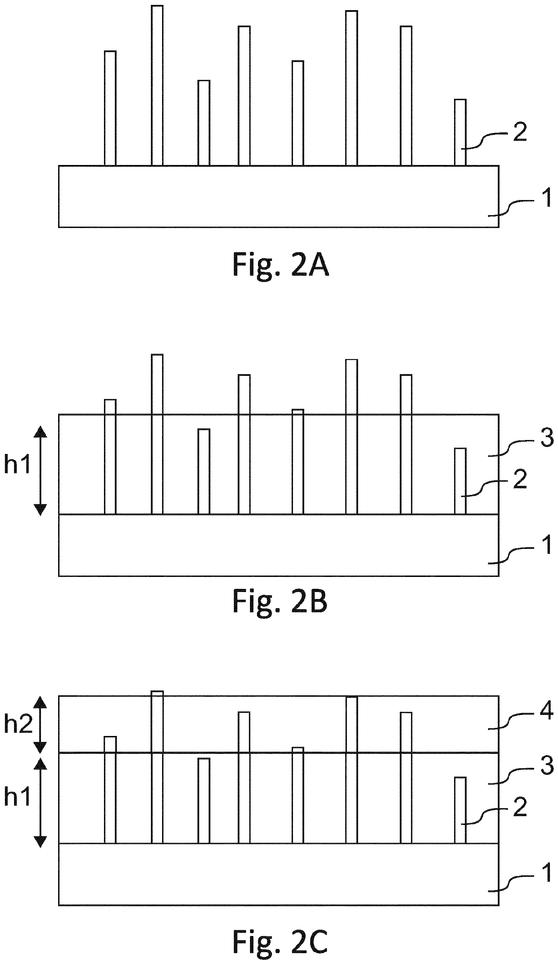

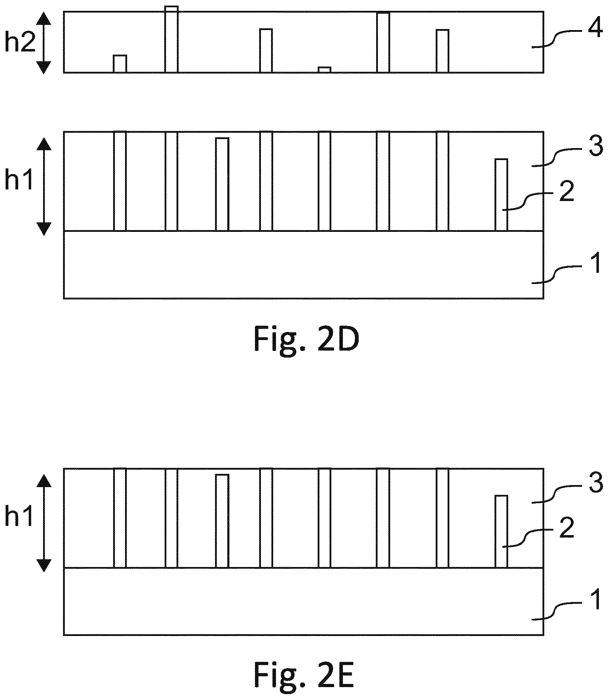

Un premier mode de réalisation d'un procédé d'homogénéisation de la hauteur d'une pluralité de fils 2 selon un premier aspect de l'invention est illustré aux figures 1 et 2A à 2E. Dans ce mode de réalisation, on dispose d'abord d'un substrat 1 comportant ladite pluralité de fils 2 dressée sur l'une de ses faces. Par ailleurs, le procédé comprend :
- une première étape E1 de dépôt (illustrée à la figure 2B) d'un premier film 3 sur la face du substrat 1 comprenant la pluralité de fils 2, ledit premier film 3 noyant la pluralité de fils 2 sur une première hauteur h1 ;
- une deuxième étape E2 de dépôt (illustrée à la figure 2C) d'un deuxième film 4 sur le premier film 3, ledit deuxième film 4 noyant au moins une partie de la pluralité de fils 2 sur une deuxième hauteur h2 ;
- une étape E3 de retrait (illustrée à la figure 2D) du deuxième film 4, la partie des fils 2 de la pluralité de fils 2 noyée dans le deuxième film 4 étant retirée en même temps que ledit deuxième film 4.

En outre, une contrainte mécanique est exercée lors de l'étape E3 de retrait entre le premier film 3 et le deuxième film 4. Comme expliqué précédemment, cette contrainte mécanique va permettre de casser les fils au niveau de l'interface entre le premier film 3 et le deuxième film 4. Ainsi, la partie des fils 2 contenue dans le deuxième film 4 va être retirée en même temps que le deuxième film 4 comme illustré à la figure 2D. On obtient alors une pluralité de fils 2 dont la hauteur n'excède pas la première hauteur h1 comme illustré à la figure 2E. Dans un mode de réalisation, cette contrainte mécanique est assurée en effectuant un retrait du deuxième film par exemple par pelage, par cisaillement ou bien encore par arrachement.

La pluralité de fils 2 dressés sur le substrat 1 peut être obtenue par croissance. Le substrat 1 peut être un substrat de silicium (Si), de saphir (Al₂O₃) ou bien encore de nitrure de gallium (GaN) en fonction du type de fils que l'on souhaite croitre. Les fils peuvent être réalisés, en fonction de l'application envisagée, dans un matériau comprenant de l'oxyde de zinc (ZnO), du Si, de l'arséniure de gallium (GaAs), du carbone (C),du GaN ou plus généralement des semiconducteurs appartenant aux familles II-VI ou III-V. La technique de croissance peut être choisie parmi une technique de MOVPE (pour *Metalorganic Vapour Phase Epitaxy* en anglais ou épitaxie en phase vapeur aux organométalliques), de croissance hydrothermale, de MBE (pour Molecular Beam Epitaxy en anglais ou épitaxie par jet moléculaire) ou bien encore de HVPE (pour Hydride Vapour Phase Epitaxy en anglais ou épitaxie d'hydrures en phase vapeur). Ces techniques de croissance permettent d'obtenir une très haute qualité cristalline. Bien sûr d'autres techniques sont également envisageables.

De manière alternative ou complémentaire, les fils peuvent être obtenus par dépôt ou tout autre procédé permettant d'obtenir une structure allongée, comme l'extrusion, l'assemblage mécanique, la gravure ou bien encore par la séparation de phase. De manière plus générale, tout procédé permettant d'obtenir une structure allongée peut être utilisée. Les fils peuvent présenter une taille millimétrique, micrométrique ou bien encore nanométrique. Des fils de taille millimétrique seront pas exemple avantageux dans les applications hautes fréquences, notamment pour la réalisation d'antennes et d'absorbeurs.

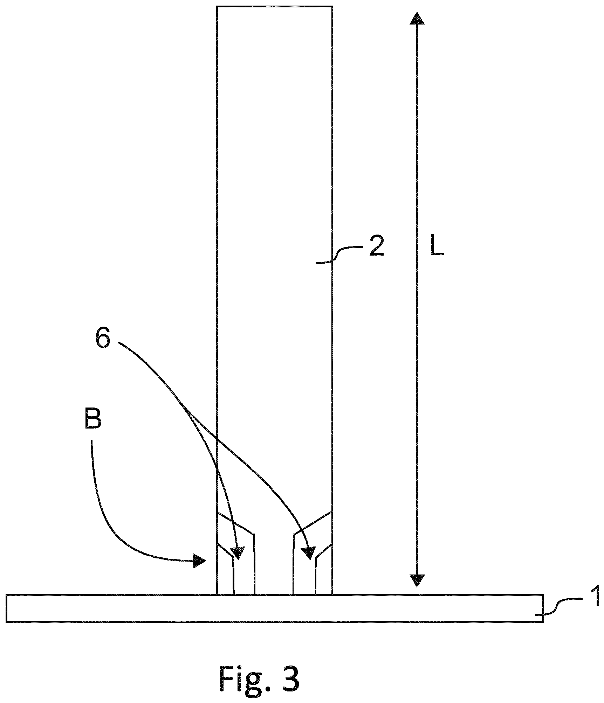

De préférence, la longueur initiale L des fils est comprise entre 10 µm et 700 µm. En effet, comme illustré par exemple à la figure 3 dans le cas d'une hétéroépitaxie de fil sur un substrat avec un désaccord de paramètre de maille, lors de la croissance des fils, des dislocations 6 se forment au niveau de la base B du fil. Ces dislocations 6 s'étendent en général sur une longueur maximale du même ordre de grandeur que le diamètre du fil depuis la base et nuisent à la qualité du cristal. Il est donc préférable de choisir une longueur initiale L de fils grande devant l'étendue des dislocations.

Dans un mode de réalisation, le matériau utilisé pour le premier film 3 et/ou le deuxième film 4 peut être choisi parmi le PDMS, le parylène, le PEN, le PVN, le PVDF ou une combinaison de ces matériaux.

Dans un mode de réalisation, le premier film 3 et/ou le deuxième film 4 sont déposés à l'aide d'un ou plusieurs dépôts centrifuges (*spin coating* en anglais). Dans un mode de réalisation, le premier film 3 est réalisé dans un premier matériau, le deuxième film 4 est réalisé dans un deuxième matériau.

La séparation entre les deux matériaux est régie principalement par leurs propriétés mécaniques et/ou chimiques. Dans le choix de ces matériaux, il est donc souhaitable de privilégier des matériaux à modules de Young ou de cisaillement différents et/ou des matériaux ayant une énergie d'adhésion faible. Autrement dit, le choix des matériaux résulte d'un compromis entre les paramètres précédemment évoqués et la force à appliquer lors du retrait des différents films.

De manière alternative ou complémentaire, il est possible d'utiliser des conditions de dépôt, des temps et/ou des températures de recuit différents pour le premier film 3 et le deuxième film 4, par exemple pour définir un degré de polymérisation différent entre les matériaux composant lesdits films.

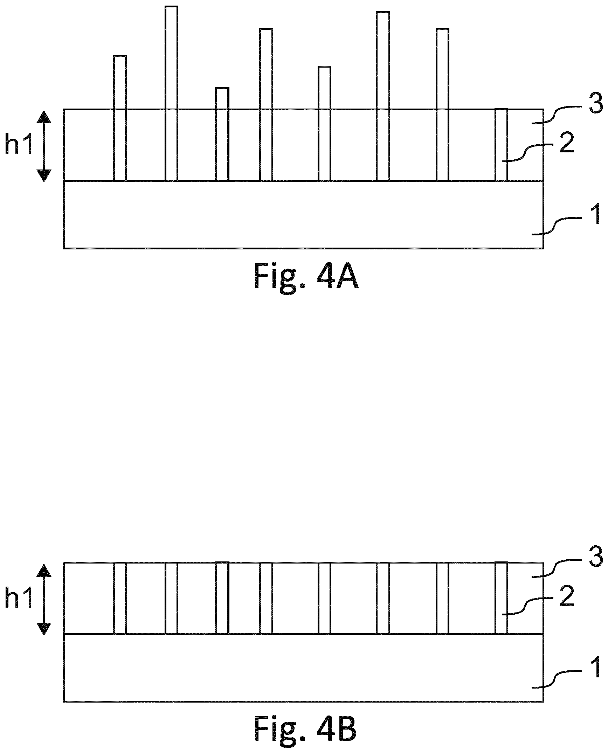

Dans un mode de réalisation illustrés aux figures 4A et 4B, la première hauteur h1 du premier film 3 est choisie comme étant inférieure ou égale à la hauteur du fil le moins haut (illustré à la figure 4A). L'homogénéité de la structure finale est alors optimale puisque, à l'issue de l'étape de retrait E3, tous les fils 2 ont une hauteur sensiblement égale à la première hauteur h1 (illustré à la figure 4B), autrement dit, inférieure ou égale à la hauteur du fil le plus court parmi les fils de la pluralité de fils.

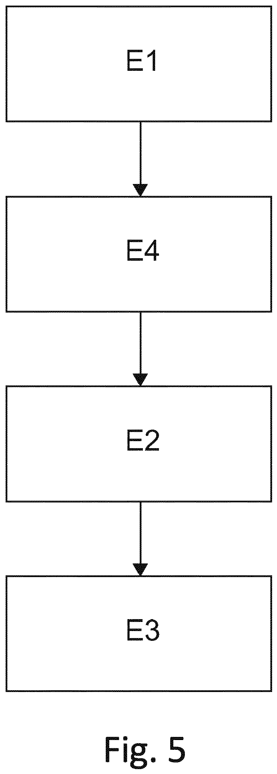

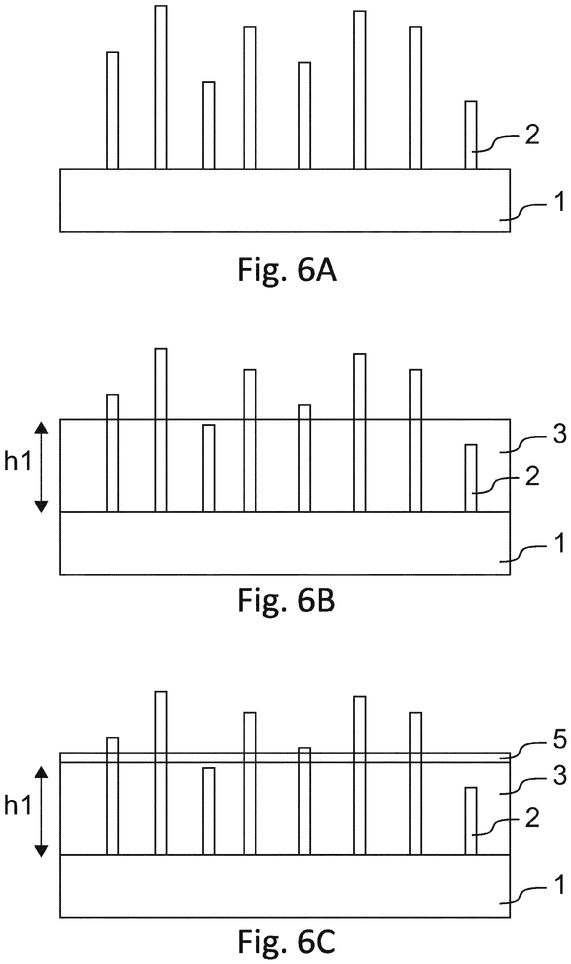

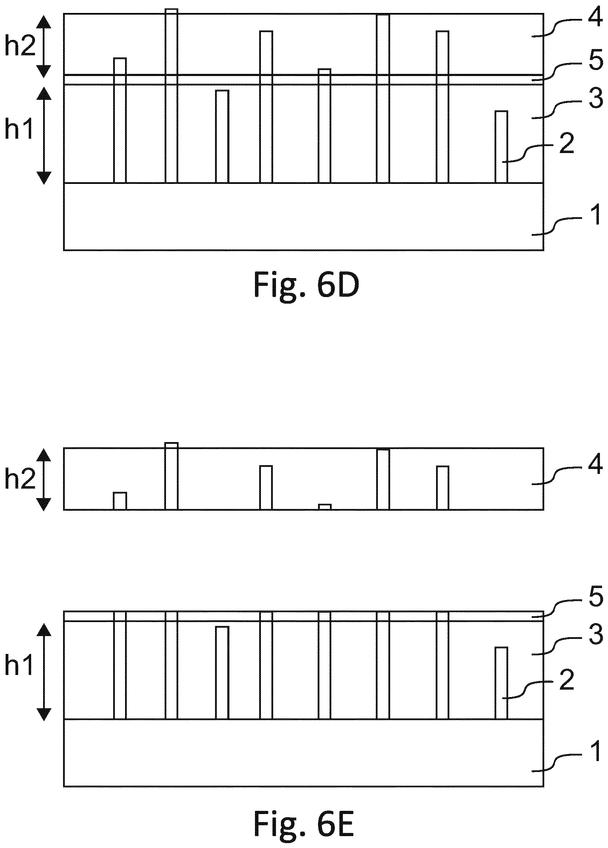

Un deuxième mode de réalisation d'un procédé d'homogénéisation selon un premier aspect de l'invention est illustré aux figures 5 et 6A à 6E. Dans ce mode de réalisation, de la même manière que dans le premier mode de réalisation, on dispose d'abord d'un substrat 1 comprenant une pluralité de fils 2 dressée sur l'une de ses faces. Par ailleurs, le procédé comprend :
- une première étape E1 de dépôt (illustrée à la figure 6B) d'un premier film 3 sur la face du substrat 1 comprenant la pluralité de fils 2, ledit premier film 3 noyant la pluralité de fils 2 sur une première hauteur h1 ;
- une troisième étape E4 de dépôt (illustrée à la figure 6C) d'une couche d'antiadhésif 5 ;
- une deuxième étape E2 de dépôt (illustrée à la figure 6D) d'un deuxième 4 film sur le premier film 3, ledit deuxième film 4 noyant la pluralité de fils 2 sur une deuxième hauteur h2 ;
- une étape E3 de retrait (illustrée à la figure 6E) du deuxième film, la partie des fils 2 de la pluralité de fils 2 noyées dans le deuxième film 4 étant retirée en même temps que ledit deuxième film 4.

Dans un mode de réalisation, l'énergie d'adhésion entre la couche d'antiadhésif 5 et le premier film 3 est plus importante que l'énergie d'adhésion entre la couche d'antiadhésif 5 et le deuxième film 4. Comme illustrée à la figure 6E, la couche d'antiadhésif 5 reste alors solidaire au moins partiellement du premier film 3 lors de l'étape E3 de retrait du deuxième film 4 et la contrainte mécanique va donc s'exercer sur les fils au niveau de l'interface entre la couche d'antiadhésif 5 et le deuxième film 4. Comme illustré à la figure 6E, le substrat comporte alors à l'issue de l'étape E3 de retrait du deuxième film, le premier film 3 et la couche d'antiadhésif 5.

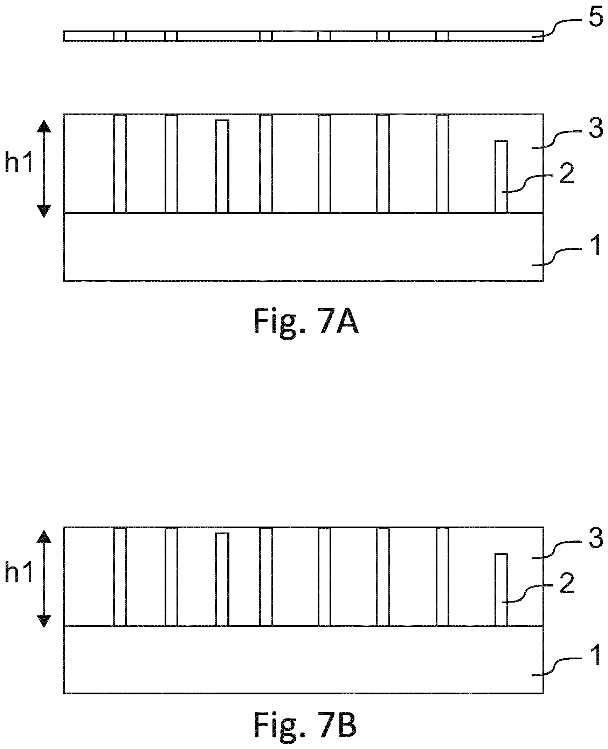

Dans un mode de réalisation illustrée aux figures 7A et 7B, le procédé peut également comprendre, après l'étape E3 de retrait du deuxième film 4, une étape de retrait de la couche d'antiadhésif 5, le substrat comportant à l'issue de cette étape le premier film 3. Cette étape de retrait peut être effectuée par attaque chimique sélective, par pelage si l'épaisseur de la couche d'antiadhésif 5 est suffisante ou par évaporation de l'adhésif (dans ce cas, l'extrémité des fils dépasse du film 3 d'une hauteur égale à l'épaisseur de la couche d'antiadhésif 5 évaporée).

Dans un mode de réalisation alternatif, l'énergie d'adhésion entre la couche d'antiadhésif 5 et le premier film 3 est moins importante que l'énergie d'adhésion entre la couche d'antiadhésif 5 et le deuxième film 4. Dans ce mode de réalisation, la couche d'antiadhésif 5 reste solidaire du deuxième film 4 lors de l'étape de retrait E3 du deuxième film 4. La couche d'antiadhésif 5 est donc retirée en même temps que le deuxième film 4.

Dans ces deux modes de réalisation, la couche d'antiadhésif 5 permet de faciliter l'étape de retrait E3 entre le premier film 3 et le deuxième film 4. De manière générale, l'épaisseur de la couche antiadhésive 5 est faible comparativement à la première hauteur h1 de sorte que la présence de la couche d'antiadhésif 5 n'influence que de manière négligeable la hauteur des fils 2 obtenus à l'issue du procédé. Autrement dit, la hauteur maximale des fils 2 obtenus à l'issu de l'étape de retrait E3 du deuxième film 4 est sensiblement égale à la première hauteur h1. Dans un mode de réalisation, la couche d'antiadhésif est réalisée à l'aide de TFCOS (tridécafluoro tetrahydrooctyltrichlorosilane), PFDTS (perfluorodecyltriethoxysilane) ou bien encore HPMC (hydroxypropylmethylcellulose).

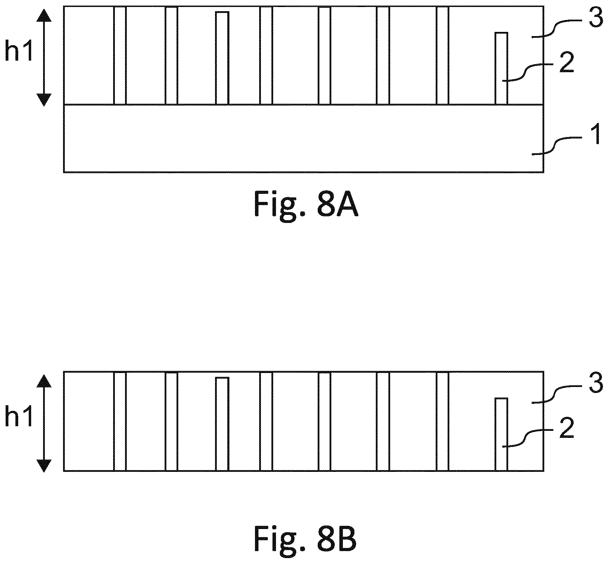

Dans un mode de réalisation illustré aux figures 8A et 8B, le procédé selon un premier aspect de l'invention comporte, après l'étape E3 de retrait du deuxième film 4 ou l'étape de retrait de la couche d'antiadhésif 5, une étape de retrait du substrat 1. Cette dernière étape permet d'obtenir une membrane dont l'épaisseur est égale à la première hauteur h1 et comporte des fils 2 de hauteur homogène.

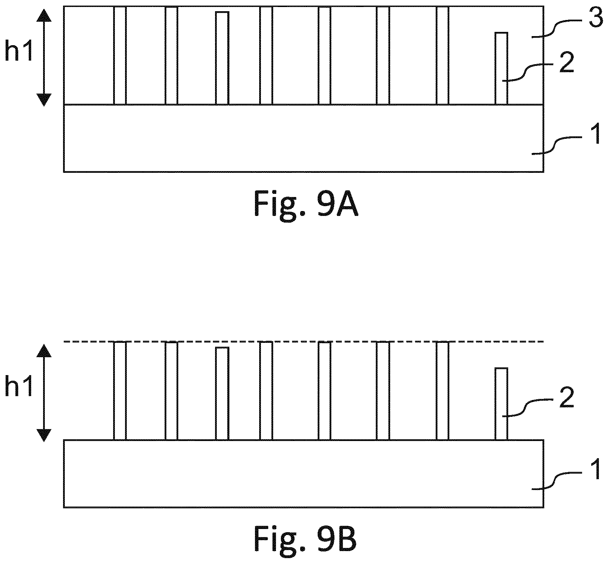

De manière alternative, comme illustré aux figure 9A et 9B, le procédé selon un premier aspect de l'invention comporte, après l'étape E3 de retrait du deuxième film 4 ou l'étape de retrait de la couche d'antiadhésif 5, une étape de retrait du premier film 3, par exemple par dissolution chimique ou attaque ionique. Cette dernière étape permet d'obtenir substrat 1 à la surface duquel se situent des fils 2 de hauteur homogène.

Dans l'ensemble de ces modes de réalisation, seul deux films sont déposés sur le substrat. Il est cependant possible d'envisager l'utilisation d'une pluralité de films, cette pluralité de films permettant d'obtenir, comme cela a été montré précédemment, une pluralité de membranes comportant chacune une pluralité de fils de hauteur homogène. Pour cela, dans un autre mode de réalisation, le procédé comporte une étape de dépôt d'une pluralité de films, chaque film pouvant être séparé par une couche d'antiadhésif, sur la surface du substrat comportant la pluralité de fils dressés, la pluralité de films noyant au moins en partie la pluralité de fils dressés. Le procédé comprend également une d'étape de retrait de la pluralité de films, cette étape de retrait permettant de retirer une à une, par exemple par pelage, les différents films déposés lors de l'étape de dépôt de la pluralité de films. On obtient ainsi une pluralité de membranes comportant chacune une pluralité de fils de hauteur homogène.

La pluralité de fils obtenue par le procédé selon un premier aspect de l'invention peut ensuite être utilisée dans la fabrication de dispositifs électroniques. Afin de comprendre l'avantage que procure l'utilisation de cette pluralité de fils 2 dans un dispositif électronique, nous allons illustrer cet usage à travers deux exemples de dispositif : un capteur piézoélectrique et un dispositif électroluminescent. Cependant, il ne s'agit là que d'exemples d'utilisation qui ne limitent en rien la présente invention mais vise à illustrer certains des avantages précédemment évoqués. En effet, il est également possible d'envisager l'utilisation d'une telle pluralité dans de nombreux dispositifs tels que des capteurs de pression ou des nanogénérateurs par exemple.

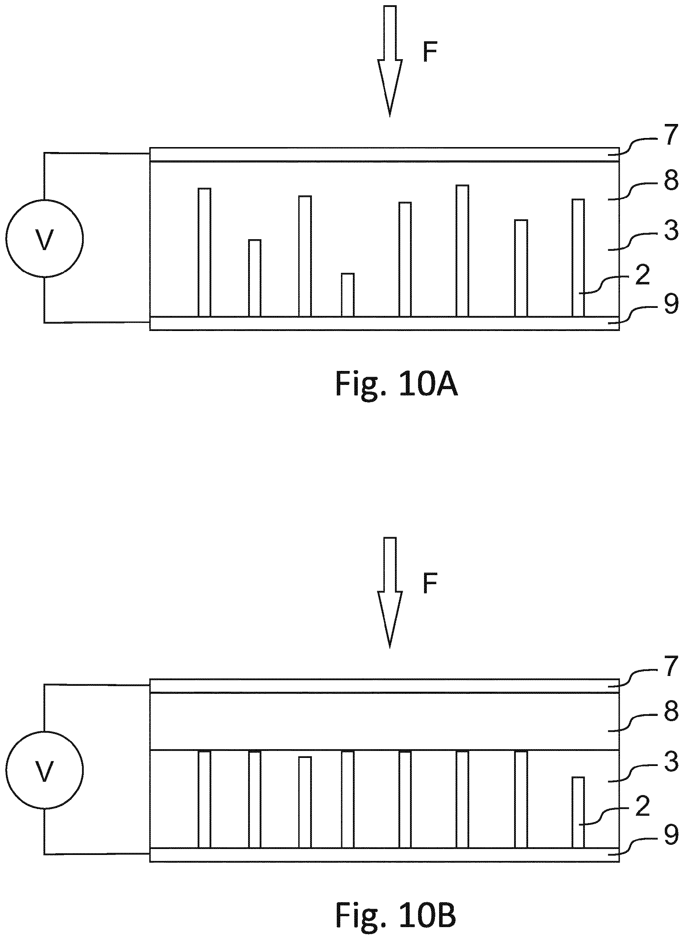

La figure 10A illustre un capteur piézoélectrique à fils selon l'état de l'art antérieur. Dans ce dispositif, une pluralité de fils 2 est située entre une première électrode 7 et une deuxième électrode 9, les fils 2 n'étant en contact électrique qu'avec la deuxième électrode 9. Lorsqu'une force F est appliquée au niveau de la première électrode 7, cette dernière va se déformer et engendrer une contrainte sur les fils 2. Il en résulte une modification de la tension aux bornes de la structure qui permet de caractériser la déformation. Un tel dispositif peut par exemple être utilisé dans un capteur de pression. Cependant, dans un capteur selon l'état de l'art antérieur, les fils 2 utilisés ne sont pas toujours homogènes ce qui nuit à la précision de mesure, une même déformation n'ayant pas la même influence en fonction de sa localisation.

Un capteur selon un premier mode de réalisation d'un deuxième aspect de l'invention visant à résoudre ce problème est illustré à la figure 10B. Dans ce mode de réalisation, les fils 2 sont obtenus à l'aide d'un procédé selon un premier aspect de l'invention et présentent donc une bonne homogénéité dans leur hauteur. Il en résulte un capteur plus précis. De plus, lorsque la précision souhaitée requiert une hauteur identique pour l'ensemble des fils 2, il est possible de choisir une première hauteur h1 du premier film 3 inférieure ou égale à la hauteur du fil 2 le moins haut. On obtient alors, comme cela a été illustré précédemment, des fils 2 de hauteur identique et donc un capteur d'une grande précision ainsi qu'une distribution plus faible des caractéristiques électriques entre les différents capteurs fabriqués.

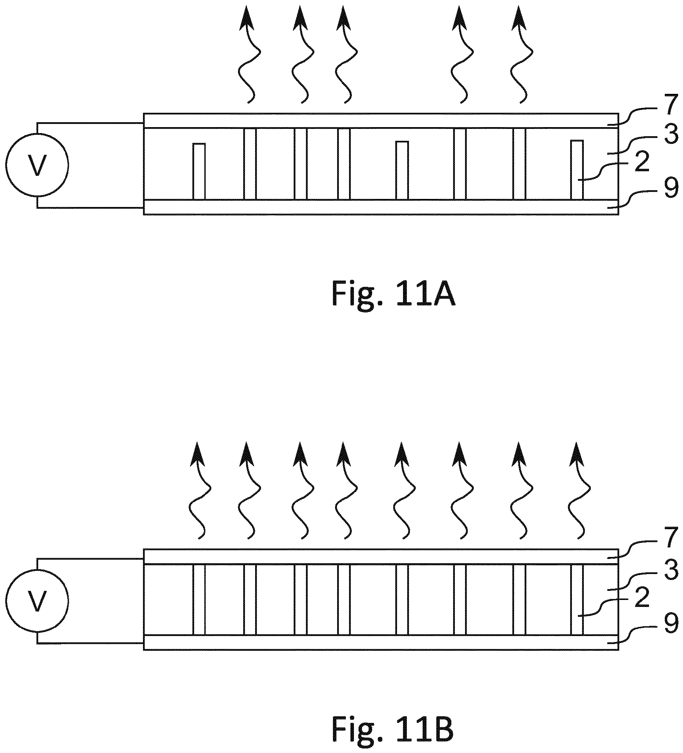

La figure 11A illustre un dispositif électroluminescent selon l'état de l'art antérieur. Dans un tel dispositif, une pluralité de fils est insérée entre une première électrode 7 et une deuxième électrode 9. Afin de pouvoir générer de la lumière, il est nécessaire qu'un courant passe à travers les fils 2 et donc que ces derniers soient connectés électriquement à la première électrode 7 et la deuxième électrode 9. Cependant, du fait de l'inhomogénéité des hauteurs de fils 2, il est très difficile d'obtenir un dispositif dans lequel l'ensemble des fils 2 est connecté de la sorte. Il en résulte une inhomogénéité de la lumière, cette dernière n'étant émise que par les fils 2 connectés à la première électrode 7 et à la deuxième électrode 9 comme cela est illustré à la figure 11A.

Un dispositif électroluminescent selon un deuxième mode de réalisation d'un deuxième aspect de l'invention est illustré à la figure 11B. Dans ce mode de réalisation, les fils 2 sont obtenus à l'aide d'un procédé selon un premier aspect de l'invention. Les fils présentent donc une bonne homogénéité dans leur hauteur et par conséquence la répartition des fils connectés à la première électrode 7 et à la deuxième électrode 9 dans le dispositif électroluminescent est meilleure que celle des dispositifs de l'état de l'art. Il en résulte un dispositif électroluminescent dans lequel la densité de courant est plus homogène et donc produisant une lumière plus homogène spectralement. En outre, en plus de s'assurer de la bonne homogénéité dans la hauteur des fils, l'emploi d'un procédé selon un premier aspect de l'invention permet de s'affranchir d'une étape de suppression des extrémités desdits fils lors de la réalisation de dispositifs comportant lesdits fils. En effet, il est souvent nécessaire de retirer ces extrémités car elles peuvent présenter des propriétés électriques gênantes pour le bon fonctionnement du dispositif. Or, la partie supérieure des fils est éliminée lors de la fabrication de la pluralité de fil, en particulier lors de l'étape de retrait du film dans lequel est noyée ladite partie supérieure. Dans ce mode de réalisation, on pourra par exemple choisir de faire croitre des fils de GaN ayant une structure de type cœur-coquille.

## Revendications

1. Procédé d'homogénéisation de la hauteur d'une pluralité de fils (2) à partir de ladite pluralité de fils (2) dressés sur une face d'un substrat (1), le procédé comprenant:
- une première étape (E1) de dépôt d'un premier film (3) sur la face du substrat (1) comprenant la pluralité de fils (2), ledit premier film (3) noyant la pluralité de fils (2) sur une première hauteur (h1) ;
- une deuxième étape (E2) de dépôt d'un deuxième film (4) sur le premier film (3), ledit deuxième film (4) noyant au moins une partie de la pluralité de fils (2) sur une deuxième hauteur (h2) ;
- une étape (E3) de retrait du deuxième film (4), la partie des fils de la pluralité de fils (2) noyées dans le deuxième film (4) étant retirée en même temps que ledit deuxième film (4) ;
une contrainte mécanique entre le premier film (3) et le deuxième film (4) étant exercée lors de l'étape de retrait.

2. Procédé selon la revendication précédente **caractérisé en ce que** la première hauteur (h1) est inférieure ou égale à la hauteur du fil le moins haut parmi les fils de la pluralité de fils (2).

3. Procédé selon l'une des revendications précédentes **caractérisé en ce qu'**il comprend, entre la première étape (E1) de dépôt et la deuxième étape (E2) de dépôt, une troisième étape (E4) de dépôt d'une couche d'antiadhésif (5).

4. Procédé selon la revendication précédente **caractérisé en ce qu'**il comprend après l'étape (E3) de retrait du deuxième film (4) et lorsque la couche d'antiadhésif (5) est restée au moins partiellement sur le premier film (3), une étape de retrait de la couche d'antiadhésif (5).

5. Procédé selon l'une des revendications précédentes **caractérisé en ce qu'**il comprend, après l'étape (E3) de retrait du deuxième film (4) ou l'étape de retrait de la couche d'antiadhésif (5), une étape de retrait du substrat (1), le premier film (3) formant alors une membrane comportant une pluralité de fils (2) de hauteur homogène.

6. Procédé selon l'une des revendications 1 à 4 **caractérisé en ce qu'**il comporte, après l'étape (E3) de retrait du deuxième film (4) ou l'étape de retrait de la couche d'antiadhésif (5), une étape de retrait du premier film (3).

7. Procédé de fabrication d'un dispositif électronique ou optoélectronique comportant une pluralité de fils (2), le procédé comprenant une étape de fabrication d'une pluralité de fils de hauteur homogène **caractérisé en ce que** ladite étape de fabrication d'une pluralité de fils de hauteur homogène met en œuvre un procédé selon l'une des revendications précédentes.

## Patentansprüche

1. Homogenisierungsverfahren der Höhe einer Vielzahl von Drähten (2) ausgehend von der genannten Vielzahl von Drähten (2), die auf einer Seite eines Substrats (1) aufgerichtet sind, wobei das Verfahren umfasst:
- einen ersten Aufbringungsschritt (E1) einer ersten Folie (3) auf der Seite des Substrats (1), umfassend die Vielzahl von Drähten (2), wobei die genannte erste Folie (3) die Vielzahl von Drähten (2) auf einer ersten Höhe (h1) versenkt;
- einen zweiten Aufbringungsschritt (E2) einer zweiten Folie (4) auf der ersten Folie (3), wobei die zweite Folie (4) wenigstens einen Teil der Vielzahl von Drähten (2) auf einer zweiten Höhe (h2) versenkt;
- einen Abnehmschritt (E3) der zweiten Folie (4), wobei der Teil der Drähte der Vielzahl von in der zweiten Folie (4) versenkten Drähten (2) gleichzeitig wie die genannte zweite Folie (4) abgenommen wird;
wobei eine mechanische Beanspruchung zwischen der ersten Folie (3) und der zweiten Folie (4) beim Abnehmschritt ausgeübt wird.

2. Verfahren gemäß dem voranstehenden Anspruch, **dadurch gekennzeichnet, dass** die erste Höhe (h1) niedriger als oder gleich der Höhe des am wenigsten hohen Drahtes von den Drähten der Vielzahl von Drähten (2) ist.

3. Verfahren gemäß einem der voranstehenden Ansprüche, **dadurch gekennzeichnet, dass** es zwischen dem ersten Aufbringungsschritt (E1) und dem zweiten Aufbringungsschritt (E2) einen dritten Aufbringungsschritt (E4) einer Anti-Haftschicht (5) umfasst.

4. Verfahren gemäß dem voranstehenden Anspruch, **dadurch gekennzeichnet, dass** es nach dem Abnehmschritt (E3) der zweiten Folie (4) und wenn die Anti-Haftschicht (5) wenigstens teilweise auf der ersten Folie (3) verblieben ist, einen Abnehmschritt der Anti-Haftschicht (5) umfasst.

5. Verfahren gemäß einem der voranstehenden Ansprüche, **dadurch gekennzeichnet, dass** es nach dem Abnehmschritt (E3) der zweiten Folie (4) oder dem Abnehmschritt der Anti-Haftschicht (5) einen Abnehmschritt des Substrats (1) umfasst, wobei die erste Folie (3) dann eine Membran bildet, die eine Vielzahl von Folien (2) homogener Höhe umfasst.

6. Verfahren gemäß einem der Ansprüche 1 bis 4, **dadurch gekennzeichnet, dass** es nach dem Abnehmschritt (E3) der zweiten Folie (4) oder dem Abnehmschritt der Anti-Haftschicht (5) einen Abnehmschritt der ersten Folie (3) umfasst.

7. Herstellungsverfahren einer elektronischen oder optisch-elektronischen Vorrichtung, umfassend eine Vielzahl von Drähten (2), wobei das Verfahren einen Herstellungsschritt einer Vielzahl von Drähten homogener Höhe umfasst, **dadurch gekennzeichnet, dass** der genannte Herstellungsschritt einer Vielzahl von Drähten homogener Höhe ein Verfahren gemäß einem der voranstehenden Ansprüche umsetzt.

## Claims

1. A method for homogenising the height of a plurality of wires (2) from said plurality of wires (2) erected on a face of a substrate (1) comprising:
- a first step (E1) of coating the face of the substrate (1) comprising the plurality of wires (2) with a first film (3), said first film (3) embedding the plurality of wires (2) over a first height (h1);
- a second step (E2) of coating the first film (3) with a second film (4), said second film (4) embedding at least one part of the plurality of wires (2) over a second height (h2);
- a step (E3) of removing the second film (4), the part of the wires of the plurality of wires (2) embedded in the second film (4) being removed at the same time as said second film (4);
a mechanical stress between the first film (3) and the second film (4) being exerted during the removal step.

2. The method according to the preceding claim, **characterised in that** said first height (h1) is smaller than or equal to the height of the lowest wire from the wires of the plurality of wires (2).

3. The method according to one of the preceding claims, **characterised in that** it comprises, between the first coating step(E1) and the second coating step (E2), a third step (E4) of coating with an anti-adhesive layer (5).

4. The method according to the preceding claim, **characterised in that** it comprises after step (E3) of removing the second film (4) and when the anti-adhesive layer (5) has remained at least partially on the first film (3), a step of removing the anti-adhesive layer (5).

5. The method according to one of the preceding claims, **characterised in that** it comprises, after step (E3) of removing the second film (4) or the step of removing the anti-adhesive layer (5), a step of removing the substrate (1), the first film (3) thereby forming a membrane including a plurality of wires (2) with a homogeneous height.

6. The method according to one of claims 1 to 4, **characterised in that** it includes, after step (E3) of removing the second film (4) or the step of removing the anti-adhesive layer (5), a step of removing the first film (3).

7. A method for manufacturing an electronic or optoelectronic device including a plurality of wires (2), the method comprising a step of manufacturing a plurality of wires with a homogeneous height **characterised in that** said step of manufacturing a plurality of wires with a homogeneous height implements a method according to one of the preceding claims.
